(19) Europäisches Patentamt
European Patent Office
Office européen des brevets

(11) EP 4 088 830 A1

(12) EUROPEAN PATENT APPLICATION
published in accordance with Art. 153(4) EPC

(43) Date of publication:
16.11.2022 Bulletin 2022/46

(21) Application number: 21738337.1

(22) Date of filing: 06.01.2021

(51) International Patent Classification (IPC):
*B05D 7/24* (2006.01) *B32B 27/30* (2006.01)
*C08F 16/24* (2006.01) *C09D 123/28* (2006.01)

(52) Cooperative Patent Classification (CPC):
B05D 7/24; B32B 27/30; C08F 16/24; C08F 24/00;
C09D 7/20; C09D 123/28; C09D 127/12;
H01L 23/29; H01L 23/31; H01L 33/56

(86) International application number:
PCT/JP2021/000252

(87) International publication number:
WO 2021/141059 (15.07.2021 Gazette 2021/28)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 08.01.2020 JP 2020001640

(71) Applicant: Daikin Industries, Ltd.
Osaka-shi, Osaka 530-8323 (JP)

(72) Inventors:
- TANAKA, Yoshito
Osaka-shi, Osaka 530-8323 (JP)
- MATSUURA, Makoto
Osaka-shi, Osaka 530-8323 (JP)
- SUZUKI, Yuuki
Osaka-shi, Osaka 530-8323 (JP)
- OGATA, Akitoshi
Osaka-shi, Osaka 530-8323 (JP)
- KISHIKAWA, Yosuke
Osaka-shi, Osaka 530-8323 (JP)

(74) Representative: Hoffmann Eitle
Patent- und Rechtsanwälte PartmbB
Arabellastraße 30
81925 München (DE)

# (54) LAYERED PRODUCT

(57) An object of the present disclosure is to provide a laminate comprising a fluoropolymer layer with insulating properties, hardness, or transparency. The present disclosure relates to a laminate comprising a fluoropolymer layer, wherein the fluoropolymer comprises, as a main component, a monomer unit represented by formula (1):

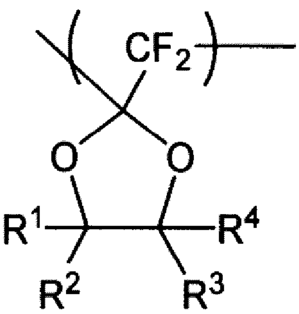

(1)

wherein $R^1$ to $R^4$ are each independently a fluorine atom, a fluoroalkyl group, or a fluoroalkoxy group.

EP 4 088 830 A1

## Description

Technical Field

The present disclosure relates to, for example, a laminate comprising a fluoropolymer layer and to a coating agent for forming a fluoropolymer layer.

Background Art

Various laminates, such as printed circuit boards containing insulating films and semiconductor substrates (wafers) containing insulating films, have been used as electronic components or in the production process of electronic components. In various displays as well, an insulating film is used as one of the layers that constitute the laminate. For example, in a liquid crystal display, a liquid crystal layer is sandwiched between substrates, with a color filter, an ITO electrode, and an insulating film being laminated between the liquid crystal layer and the substrate. In a light-emitting component, a transparent sealing resin is laminated for sealing a light-emitting element mounted on a substrate (Patent Literature 1).

These laminates are required to have insulating properties, hardness, transparency, etc. that are suitable for their use.

Citation List

Patent Literature

PTL 1: JP2015-133505A

Summary of Invention

Technical Problem

An object of the present disclosure is to provide a laminate comprising a fluoropolymer layer with insulating properties, hardness, or transparency. Another object of the present disclosure is to provide a coating agent for forming a fluoropolymer layer.

Solution to Problem

The present disclosure includes the following embodiments.

Item 1.

A laminate comprising a fluoropolymer layer,

wherein
the fluoropolymer comprises, as a main component, a monomer unit represented by formula (1):

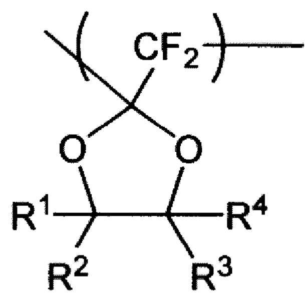

(1)

wherein $R^1$ to $R^4$ are each independently a fluorine atom, a fluoroalkyl group, or a fluoroalkoxy group.

Item 2.

The laminate according to Item 1, wherein the fluoropolymer further comprises a fluoroolefin unit.

Item 3.

The laminate according to Item 2, wherein the fluoroolefin unit is at least one member selected from the group consisting of a fluorine-containing perhaloolefin unit, a vinylidene fluoride unit, a trifluoroethylene unit, a pentafluoropropylene unit, and a 1,1,1,2-tetrafluoro-2-propylene unit.

Item 4.

The laminate according to Item 3, wherein the fluorine-containing perhaloolefin unit is at least one member selected from the group consisting of a chlorotrifluoroethylene unit, a tetrafluoroethylene unit, a hexafluoropropylene unit, a perfluoro(methyl vinyl ether) unit, a perfluoro(ethyl vinyl ether) unit, a perfluoro(propyl vinyl ether) unit, a perfluoro(butyl vinyl ether) unit, and a perfluoro(2,2-dimethyl-1,3-dioxol) unit.

Item 5.

The laminate according to Item 2, wherein the fluoroolefin unit is at least one member selected from the group consisting of a chlorotrifluoroethylene unit, a tetrafluoroethylene unit, a hexafluoropropylene unit, a perfluoro(methyl vinyl ether) unit, and a perfluoro(propyl vinyl ether) unit.

Item 6.

The laminate according to any one of Items 1 to 5, wherein the fluoropolymer layer has an average thickness of 10 nm or more.

Item 7.

The laminate according to any one of Items 1 to 6, further comprising an insulating layer as one or more other layers constituting the laminate.

Item 8.

The laminate according to Item 7, wherein the insulating layer is a printed circuit board.

Item 9.

The laminate according to Item 7 or 8, wherein the fluoropolymer layer is an insulating film for printed circuit boards.

Item 10.

The laminate according to any one of Items 1 to 6, further comprising a semiconductor substrate as one or more other layers constituting the laminate.

Item 11.

The laminate according to Item 10, wherein the semiconductor substrate is a GaN or GaAs substrate.

Item 12.

The laminate according to Item 10 or 11, wherein the fluoropolymer layer is an insulating film for semiconductors.

Item 13.

The laminate according to any one of Items 1 to 6, further comprising an acrylic hard coat layer, an epoxy hard coat layer, a polyethylene terephthalate layer, or a cellulose triacetate layer as one or more other layers constituting the laminate.

Item 14.

The laminate according to Item 13, wherein the fluoropolymer layer is a protective film for displays.

Item 15.

The laminate according to any one of Items 1 to 6, 13, and 14, wherein the one or more other layers constituting the laminate have a total light transmittance of 90% or more.

Item 16.

The laminate according to Item 15, wherein the one or more other layers comprise optical glass or optical resin.

Item 17.

The laminate according to any one of Items 1 to 6, further comprising a light-emitting-element-containing substrate as one or more other layers constituting the laminate.

Item 18.

The laminate according to Item 17, wherein the fluoropolymer layer is a light-emitting-element-encapsulating layer.

Item 19.

The laminate according to any one of Items 1 to 18, wherein the number of layers constituting the laminate is 2, 3, or 4.

Item 20.

The laminate according to any one of Items 1 to 19, wherein the fluoropolymer layer has an indentation hardness of 250 $N/mm^2$ or more and 1000 $N/mm^2$ or less.

Item 21.

The laminate according to any one of Items 1 to 20, wherein the fluoropolymer layer has an indentation elastic modulus of 2.5 GPa or more and 10 GPa or less.

Item 22.

The laminate according to any one of Items 1 to 21, wherein the fluoropolymer has a glass transition temperature of 110°C or higher.

Item 23.

The laminate according to any one of Items 1 to 22, wherein the fluoropolymer layer has a relative permittivity at 6 GHz of 1.5 or more and 2.5 or less.

Item 24.

The laminate according to any one of Items 1 to 23, wherein the fluoropolymer layer has a dielectric dissipation factor at 6 GHz of 0.00005 or more and 0.0002 or less.

Item 25.

A coating agent for forming a fluoropolymer layer of a laminate comprising the fluoropolymer layer, the coating agent comprising a fluoropolymer and an aprotic solvent,

wherein
the fluoropolymer comprises, as a main component, a monomer unit represented by formula (1):

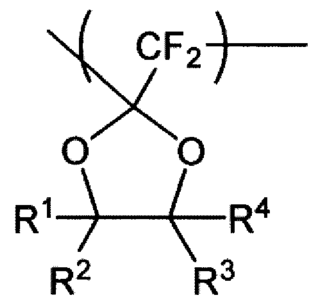

(1)

wherein $R^1$ to $R^4$ are each independently a fluorine atom, a fluoroalkyl group, or a fluoroalkoxy group.

Item 26.

The coating agent according to Item 25, wherein the content of the fluoropolymer is 20 mass% or more and 65 mass% or less based on the total mass of the coating agent.

Item 27.

The coating agent according to Item 25 or 26, wherein the aprotic solvent is at least one solvent selected from the group consisting of perfluoroaromatic compounds, perfluorotrialkylamines, perfluoroalkanes, hydrofluorocarbons, perfluorocyclic ethers, hydrofluoroethers, and olefin compounds containing at least one chlorine atom.

Item 28.

The coating agent according to any one of Items 25 to 27, wherein the aprotic solvent is at least one hydrofluoroether.

Advantageous Effects of Invention

The present disclosure is capable of providing a laminate comprising a fluoropolymer layer with insulating properties, hardness, or transparency. The present disclosure is capable of providing a laminate comprising a fluoropolymer layer with ultraviolet resistance. The present disclosure is capable of providing a coating agent for forming a fluoropolymer layer.

Description of Embodiments

The above overview of the present disclosure is not intended to describe each of the disclosed embodiments or all of the implementations of the present disclosure.
The following description of the present disclosure illustrates embodiments of examples in more detail.
In several parts of the present disclosure, guidance is provided through examples, and these examples can be used in various combinations.
In each case, the group of examples can function as a non-exclusive and representative group.
All publications, patents, and patent applications cited herein are incorporated herein by reference in their entirety.

<u>Terms</u>

Unless otherwise specified, the symbols and abbreviations in the present specification can be understood in the sense commonly used in the technical field to which the present disclosure pertains, according to the context of the present specification.
In the present specification, the terms "comprise" and "contain" are used with the intention of including the terms "consisting essentially of" and "consisting of."
Unless otherwise specified, the steps, treatments, or operations described in the present specification can be

performed at room temperature. In the present specification, room temperature can mean a temperature within the range of 10°C or higher and 40°C or lower.

In the present specification, the phrase "$C_n$-$C_m$" (n and m are each a number) indicates that the number of carbon atoms is n or more and m or less, as would be commonly understood by a person skilled in the art.

In the present specification, the simple expression "molecular weight" means mass average molecular weight. The mass average molecular weight is determined as follows.

Mass Average Molecular Weight

The mass average molecular weight is measured by using the following GPC analysis method. Specifically, the mass average molecular weight is a value determined by the method described in a specific example of the present disclosure.

GPC Analysis Method

Sample Preparation Method

A polymer is dissolved in perfluorobenzene to prepare a 2 mass% polymer solution, and the polymer solution is passed through a membrane filter (0.22 μm) to obtain a sample solution.

Measurement Method

Standard sample for measurement of molecular weight: polymethyl methacrylate
Detection method: RI (differential refractometer)

In the present specification, the "indentation hardness" and "indentation elastic modulus" are determined as follows.

Indentation Hardness and Indentation Elastic Modulus

The indentation hardness ($H_{IT}$; indentation hardness) of a sample is measured using an ENT-2100 ultra-fine hardness tester produced by Nanotec Corporation. The indentation elastic modulus is also measured at the same time. The test is performed by adjusting the indentation depth to be 1/10 or less of the thickness. Specifically, the indentation hardness and indentation elastic modulus are values determined by the method described in a specific example of the present disclosure.

In the present specification, the "total light transmittance" and "haze" are determined as follows.

Measurement Method for Total Light Transmittance and Haze

The total light transmittance and haze are measured using an NDH 7000SPII haze meter (produced by Nippon Denshoku Industries Co., Ltd.) in accordance with JIS K7136 (haze value) and JIS K7361-1 (total light transmittance). A film with an average film thickness of 100 μm is used as the sample to be measured. Specifically, the total light transmittance and haze are values determined by the method described in a specific example of the present disclosure.

In the present specification, the "transmittance" at a specific wavelength is determined as follows.

Transmittance at Each Wavelength

The transmittance at a specific wavelength of a sample is measured using a Hitachi U-4100 spectrophotometer. A film with an average film thickness of 100 μm is used as the sample. An integrating sphere detector is used as the detector. Specifically, the transmittance is a value determined by the method described in a specific example of the present disclosure.

In the present specification, the "glass transition temperature" is determined as follows.

Glass Transition Temperature (Tg)

The temperature is increased (first run), decreased, and then increased (second run) at 10°C/minute in the

temperature range of 30°C or higher and 200°C or lower using a DSC (differential scanning calorimeter; Hitachi High-Tech Science Corporation, DSC7000); the midpoint of the endothermic curve in the second run is determined to be the glass transition temperature (°C). Specifically, the glass transition temperature is a value determined by the method described in a specific example of the present disclosure.

In the present specification, the expression "thickness" or simply "film thickness" with respect to a film means an average film thickness. The "average film thickness" is determined as follows.

Average Film Thickness

The average film thickness is the average value of a thickness measured 5 times with a micrometer. When measuring the thickness of a film itself is difficult, such as when a film formed on a base material of a substrate etc. cannot be peeled off, the average film thickness is calculated by measuring the thickness of the base material before film formation and the thickness of the base material after film formation 5 times each with a micrometer, and subtracting the average value of the thickness before film formation from the average value of the thickness after film formation.

When the measurement cannot be performed with a micrometer, the film thickness obtained by measuring the line profile of the cut surface of a film to be measured with an atomic force microscope (AFM) is defined as the average film thickness.

Specifically, the average film thickness is a value determined by the method described in a specific example of the present disclosure.

In the present specification, the "relative permittivity" and "dielectric dissipation factor" are determined as follows.

Relative Permittivity and Dielectric Dissipation Factor

The relative permittivity and dielectric dissipation factor at frequencies of 10 GHz or more (e.g., 10, 20, 28, 60, and 80 GHz) are determined by a split-cylinder resonator method. A resonator corresponding to each frequency produced by KANTO Electronic Application and Development Inc. is used as the split cylinder, and a Keysight N5290A is used as the network spectrum analyzer. For measurement at less than 20 GHz, a film with a thickness of 100 μm, a width of 62 mm, and a length of 75 mm is used as the sample to be measured, and for measurement at 20 GHz or more, a film with a thickness of 100 μm, a width of 34 mm, and a length of 45 mm is used as the sample to be measured. The measurement temperature is 25°C. Specifically, the relative permittivity and dielectric dissipation factor are values determined by the method described in a specific example of the present disclosure.

The relative permittivity and dielectric dissipation factor at 6 GHz are measured using a cavity resonator produced by KANTO Electronic Application and Development Inc. The sample is formed into a cylinder shape (2 mm dia. × 110 mm).

The real part of the complex relative permittivity is determined from the change in the resonance frequency indicated by the cavity resonator, and the imaginary part of the complex relative permittivity is determined from the change in the Q value. The relative permittivity and dielectric dissipation factor are then calculated according to the following formulas. Specifically, the relative permittivity and dielectric dissipation factor are values determined by the method described in a specific example of the present disclosure.

$$\varepsilon_r^* = \varepsilon_r' - j\varepsilon_r''$$

$$\varepsilon_r' = \varepsilon_r$$

$$\varepsilon_r'' = \varepsilon_r \tan\delta$$

$$\tan\delta = \frac{\varepsilon_r''}{\varepsilon_r'}$$

In the formulas, $\varepsilon_r^*$ represents a complex relative permittivity, $\varepsilon_r'$ represents a relative permittivity, $\varepsilon_r''$ represents a relative dielectric loss factor, and tan δ represents a dielectric dissipation factor.

In the present specification, unless otherwise specified, examples of "alkyl" include linear or branched $C_1$-$C_{10}$ alkyl, such as methyl, ethyl, propyl, isopropyl, butyl, isobutyl, sec-butyl, tert-butyl, pentyl, isopentyl, neopentyl, hexyl, heptyl, octyl, nonyl, and decyl.

In the present specification, unless otherwise specified, "fluoroalkyl" is alkyl in which at least one hydrogen atom is replaced with a fluorine atom. "Fluoroalkyl" can be linear or branched fluoroalkyl.

The number of carbon atoms in "fluoroalkyl" can be, for example, 1 to 12, 1 to 6, 1 to 5, 1 to 4, 1 to 3, 6, 5, 4, 3, 2, or 1.

The number of fluorine atoms in "fluoroalkyl" can be 1 or more (e.g., 1 to 3, 1 to 5, 1 to 9, 1 to 11, or 1 to the maximum substitutable number).

"Fluoroalkyl" includes perfluoroalkyl.

"Perfluoroalkyl" is alkyl in which all hydrogen atoms are replaced with fluorine atoms.

Examples of perfluoroalkyl include trifluoromethyl ($CF_3$-), pentafluoroethyl ($C_2F_5$-), heptafluoropropyl ($CF_3CF_2CF_2$-), and heptafluoroisopropyl ($(CF_3)_2CF$-).

Specific examples of "fluoroalkyl" include monofluoromethyl, difluoromethyl, trifluoromethyl ($CF_3$-), 2,2,2-trifluoroethyl ($CF_3CH_2$-), perfluoroethyl ($C_2F_5$-), tetrafluoropropyl (e.g., $HCF_2CF_2CH_2$-), hexafluoropropyl (e.g., $(CF_3)_2CH$-), perfluorobutyl (e.g., $CF_3CF_2CF_2CF_2$-), octafluoropentyl (e.g., $HCF_2CF_2CF_2CF_2CH_2$-), perfluoropentyl (e.g., $CF_3CF_2CF_2CF_2CF_2$-), perfluorohexyl (e.g., $CF_3CF_2CF_2CF_2CF_2CF_2$-), and the like.

In the present specification, unless otherwise specified, "alkoxy" can be a group represented by RO-, wherein R is alkyl (e.g., $C_1$-$C_{10}$ alkyl).

Examples of "alkoxy" include linear or branched $C_1$-$C_{10}$ alkoxy, such as methoxy, ethoxy, propoxy, isopropoxy, butoxy, isobutoxy, sec-butoxy, tert-butoxy, pentyloxy, isopentyloxy, neopentyloxy, hexyloxy, heptyloxy, octyloxy, nonyloxy, and decyloxy.

In the present specification, unless otherwise specified, "fluoroalkoxy" is alkoxy in which at least one hydrogen atom is replaced with a fluorine atom. "Fluoroalkoxy" can be linear or branched fluoroalkoxy.

The number of carbon atoms in "fluoroalkoxy" can be, for example, 1 to 12, 1 to 6, 1 to 5, 1 to 4, 1 to 3, 6, 5, 4, 3, 2, or 1.

The number of fluorine atoms in "fluoroalkoxy" can be 1 or more (e.g., 1 to 3, 1 to 5, 1 to 9, 1 to 11, or 1 to the maximum substitutable number).

"Fluoroalkoxy" includes perfluoroalkoxy.

"Perfluoroalkoxy" is alkoxy in which all hydrogen atoms are replaced with fluorine atoms.

Examples of "perfluoroalkoxy" include trifluoromethoxy ($CF_3O$-), pentafluoroethoxy ($C_2F_5O$-), heptafluoropropoxy ($CF_3CF_2CF_2O$-), and heptafluoroisopropoxy ($(CF_3)_2CFO$-).

Specific examples of "fluoroalkoxy" include monofluoromethoxy, difluoromethoxy, trifluoromethoxy, 2,2,2-trifluoroethoxy ($CF_3CH_2O$-), perfluoroethoxy ($C_2F_5O$-), tetrafluoropropyloxy (e.g. $HCF_2CF_2CH_2O$-), hexafluoropropyloxy (e.g., $(CF_3)_2CHO$-), perfluorobutyloxy (e.g., $CF_3CF_2CF_2CF_2O$-), octafluoropentyloxy (e.g., $HCF_2CF_2CF_2CF_2CH_2O$-), perfluoropentyloxy (e.g., $CF_3CF_2CF_2CF_2CF_2O$-), perfluorohexyloxy (e.g., $CF_3CF_2CF_2CF_2CF_2CF_2O$-), and the like.

## Laminate

One embodiment of the present disclosure is a laminate comprising a specific fluoropolymer layer (a layer containing a fluoropolymer). The laminate may be any laminate as long as it comprises a specific fluoropolymer layer, and may be, for example, a printed circuit board comprising a fluoropolymer layer as an insulating layer on the substrate, a semiconductor substrate comprising a fluoropolymer layer as an insulating film (e.g., an interlayer insulating film) on the substrate, a display substrate comprising a fluoropolymer layer as a protective film on the substrate, and a light-emitting-element-containing substrate comprising a fluoropolymer layer as a light-emitting-element-encapsulating layer on the substrate.

In these laminates, one or more other layers may be or may not be interposed between the fluoropolymer layer and the substrate layer. Such other layers may be appropriately selected by a person skilled in the art according to the use of the laminate.

The laminate may be composed of at least one layer in addition to the fluoropolymer layer. The laminate can have, for example, a 2-layer, 3-layer, 4-layer, 5-layer, 6-layer, or 7-layer structure. The laminate preferably has a 2-, 3-, 4-, 5-, or 6-layer structure, more preferably a 2-, 3-, 4-, or 5-layer structure, and even more preferably a 2-, 3-, or 4-layer structure.

The fluoropolymer layer of the laminate comprises a fluoropolymer. The fluoropolymer comprises, as a main component, a monomer unit represented by formula (1):

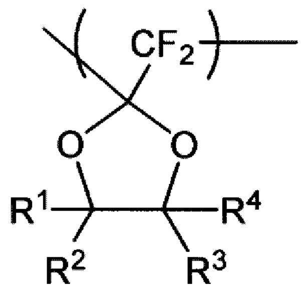

(1)

wherein $R^1$ to $R^4$ are each independently a fluorine atom, a fluoroalkyl group, or a fluoroalkoxy group (this monomer unit may be referred to as "unit (1)" in the present specification).

The fluoropolymer layer has excellent insulating properties, hardness, translucency, or light resistance by comprising the fluoropolymer.

In the present specification, phrases such as "comprising a monomer unit as a main component" mean that the percentage of the specific monomer unit is 50 mol% or more based on the total monomer units in a polymer.

Unit (1) as a monomer unit constituting the fluoropolymer may be used singly or in a combination of two or more.

The percentage of unit (1) may be, for example, 70 mol% or more, preferably 80 mol% or more, more preferably 90 mol% or more, and particularly preferably 100 mol%, based on the total monomer units of the fluoropolymer.

In each of $R^1$ to $R^4$, fluoroalkyl can be, for example, linear or branched $C_1$-$C_5$ fluoroalkyl, linear or branched $C_1$-$C_4$ fluoroalkyl, linear or branched $C_1$-$C_3$ fluoroalkyl, or $C_1$-$C_2$ fluoroalkyl.

The linear or branched $C_1$-$C_5$ fluoroalkyl is preferably linear or branched $C_1$-$C_5$ perfluoroalkyl.

The linear or branched $C_1$-$C_4$ fluoroalkyl is preferably linear or branched $C_1$-$C_4$ perfluoroalkyl.

The linear or branched $C_1$-$C_3$ fluoroalkyl is preferably linear or branched $C_1$-$C_3$ perfluoroalkyl.

The $C_1$-$C_2$ fluoroalkyl group is preferably $C_1$-$C_2$ perfluoroalkyl.

In each of $R^1$ to $R^4$, fluoroalkoxy can be, for example, linear or branched $C_1$-$C_5$ fluoroalkoxy, linear or branched $C_1$-$C_4$ fluoroalkoxy, linear or branched $C_1$-$C_3$ fluoroalkoxy, or $C_1$-$C_2$ fluoroalkoxy.

The linear or branched $C_1$-$C_5$ fluoroalkoxy is preferably linear or branched $C_1$-$C_5$ perfluoroalkoxy.

The linear or branched $C_1$-$C_4$ fluoroalkoxy is preferably linear or branched $C_1$-$C_4$ perfluoroalkoxy.

The linear or branched $C_1$-$C_3$ fluoroalkoxy is preferably linear or branched $C_1$-$C_3$ perfluoroalkoxy.

The $C_1$-$C_2$ fluoroalkoxy is preferably $C_1$-$C_2$ perfluoroalkoxy.

$R^1$ to $R^4$ can be each independently fluorine, linear or branched $C_1$-$C_5$ fluoroalkyl, or linear or branched $C_1$-$C_5$ fluoroalkoxy.

$R^1$ to $R^4$ can be each independently fluorine, linear or branched $C_1$-$C_5$ perfluoroalkyl, or linear or branched $C_1$-$C_5$ perfluoroalkoxy.

$R^1$ to $R^4$ can be each independently fluorine, linear or branched $C_1$-$C_4$ fluoroalkyl, or linear or branched $C_1$-$C_4$ fluoroalkoxy.

$R^1$ to $R^4$ can be each independently fluorine, linear or branched $C_1$-$C_4$ perfluoroalkyl, or linear or branched $C_1$-$C_4$ perfluoroalkoxy.

$R^1$ to $R^4$ can be each independently fluorine, linear or branched $C_1$-$C_3$ fluoroalkyl, or linear or branched $C_1$-$C_3$ fluoroalkoxy.

$R^1$ to $R^4$ can be each independently fluorine, linear or branched $C_1$-$C_3$ perfluoroalkyl, or linear or branched $C_1$-$C_3$ perfluoroalkoxy.

$R^1$ to $R^4$ can be each independently fluorine, $C_1$-$C_2$ fluoroalkyl, or $C_1$-$C_2$ fluoroalkoxy.

$R^1$ to $R^4$ can be each independently fluorine, $C_1$-$C_2$ perfluoroalkyl, or $C_1$-$C_2$ perfluoroalkoxy.

$R^1$ to $R^4$ can be each independently fluorine, trifluoromethyl, pentafluoroethyl, or trifluoromethoxy.

At least one of $R^1$ to $R^4$ can be fluorine, and the other groups in $R^1$ to $R^4$ can be independently $C_1$-$C_2$ perfluoroalkyl or $C_1$-$C_2$ perfluoroalkoxy when two or more such other groups are present.

At least two of $R^1$ to $R^4$ can be fluorine, and the other groups in $R^1$ to $R^4$ can be independently $C_1$-$C_2$ perfluoroalkyl or $C_1$-$C_2$ perfluoroalkoxy when two or more such other groups are present.

At least three of $R^1$ to $R^4$ can be fluorine, and the other group in $R^1$ to $R^4$ can be $C_1$-$C_2$ perfluoroalkyl or $C_1$-$C_2$ perfluoroalkoxy.

At least three of $R^1$ to $R^4$ can be fluorine atoms, and the other group in $R^1$ to $R^4$ can be $C_1$-$C_2$ perfluoroalkyl.

$R^1$ to $R^4$ can be all fluorine atoms.

Unit (1) can be a monomer unit represented by the following formula (1-1) (this unit may be referred to as "unit (1-1)" in the present specification).

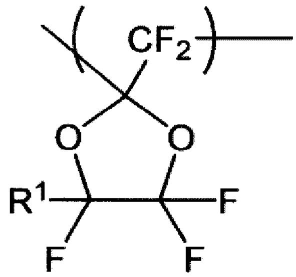

(1-1)

In the formula, $R^1$ is a fluorine atom, a fluoroalkyl group, or a fluoroalkoxy group.

Unit (1-1) as a monomer unit constituting the fluoropolymer may be used singly or in a combination of two or more.

In unit (1-1), $R^1$ can be fluorine, linear or branched $C_1$-$C_5$ fluoroalkyl, or linear or branched $C_1$-$C_5$ fluoroalkoxy.

In unit (1-1), $R^1$ can be fluorine, linear or branched $C_1$-$C_5$ perfluoroalkyl, or linear or branched $C_1$-$C_5$ perfluoroalkoxy.

In unit (1-1), $R^1$ can be fluorine, linear or branched $C_1$-$C_4$ fluoroalkyl, or linear or branched $C_1$-$C_4$ fluoroalkoxy.

In unit (1-1), $R^1$ can be fluorine, linear or branched $C_1$-$C_4$ perfluoroalkyl, or linear or branched $C_1$-$C_4$ perfluoroalkoxy.

In unit (1-1), $R^1$ can be fluorine, linear or branched $C_1$-$C_3$ fluoroalkyl, or linear or branched $C_1$-$C_3$ fluoroalkoxy.

In unit (1-1), $R^1$ can be fluorine, linear or branched $C_1$-$C_3$ perfluoroalkyl, or linear or branched $C_1$-$C_3$ perfluoroalkoxy.

In unit (1-1), $R^1$ can be fluorine, $C_1$-$C_2$ fluoroalkyl, or $C_1$-$C_2$ fluoroalkoxy.

In unit (1-1), $R^1$ can be fluorine, $C_1$-$C_2$ perfluoroalkyl, or $C_1$-$C_2$ perfluoroalkoxy.

In unit (1-1), $R^1$ can be fluorine, trifluoromethyl, pentafluoroethyl, or trifluoromethoxy.

In unit (1-1), $R^1$ can be $C_1$-$C_2$ perfluoroalkyl or $C_1$-$C_2$ perfluoroalkoxy.

In unit (1-1), $R^1$ can be $C_1$-$C_2$ perfluoroalkyl.

Preferred examples of unit (1-1) include a monomer unit represented by the following formula (1-11) (this monomer unit may be referred to as "unit (1-11)" in the present specification).

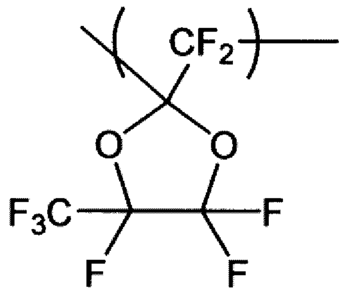

(1-11)

The fluoropolymer may comprise a fluoroolefin unit in addition to unit (1).

The fluoroolefin unit may be used singly or in a combination of two or more.

The percentage of the fluoroolefin unit can be 50 mol% or less, preferably 30 mol% or less, more preferably 20 mol% or less, even more preferably 10 mol% or less, and particularly preferably 0 mol%, based on the total monomer units.

The fluoroolefin unit is a monomer unit that is formed after polymerization of a monomer containing fluorine and a carbon-carbon double bond.

The atoms constituting the fluoroolefin unit may be only fluorine, halogen other than fluorine, carbon, hydrogen, and oxygen.

The atoms constituting the fluoroolefin unit may be only fluorine, halogen other than fluorine, carbon, and hydrogen.

The atoms constituting the fluoroolefin unit may be only fluorine, carbon, and hydrogen.

The atoms constituting the fluoroolefin unit may be only fluorine and carbon.

The fluoroolefin unit includes at least one unit selected from the group consisting of a fluorine-containing perhaloolefin unit, a vinylidene fluoride unit ($-CH_2-CF_2-$), a trifluoroethylene unit ($-CFH-CF_2-$), a pentafluoropropylene unit ($-CFH-CF(CF_3)-$, $-CF_2-CF(CHF_2)-$), a 1,1,1,2-tetrafluoro-2-propylene unit ($-CH_2-CF(CF_3)-$), and the like.

The fluorine-containing perhaloolefin unit is a monomer unit that is formed after polymerization of a monomer containing fluorine and a carbon-carbon double bond, and optionally halogen other than fluorine.

The fluorine-containing perhaloolefin unit includes at least one member selected from the group consisting of a chlorotrifluoroethylene unit ($-CFCl-CF_2-$), a tetrafluoroethylene unit ($-CF_2-CF_2-$), a hexafluoropropylene unit ($-CF_2-CF(CF_3)-$), a perfluoro (methyl vinyl ether) unit ($-CF_2-CF(OCF_3)$ -), a perfluoro (ethyl vinyl ether) unit ($-CF_2-CF(OC_2F_5)-$), perfluoro (propyl vinyl ether) unit ($-CF_2-CF(OCF_2C_2F_5)-$), perfluoro (butyl vinyl ether) unit ($-CF_2-CF(O(CF_2)_2C_2F_5)-$), and a perfluoro(2,2-dimethyl-1,3-dioxol) unit (-CF-CAF- (wherein A represents a perfluorodioxolane ring formed with the adjacent carbon atom shown in the formula, with two trifluoromethyl bonded to the carbon atom at position 2 of the dioxolane ring).

The fluoroolefin unit includes at least one member selected from the group consisting of a chlorotrifluoroethylene unit, a tetrafluoroethylene unit, a hexafluoropropylene unit, a perfluoro(methyl vinyl ether) unit, and a perfluoro(propyl vinyl ether) unit.

The fluoropolymer may further contain one or more other monomer units in addition to unit (1) and the fluoroolefin unit. However, it is preferable to contain no other monomer units.

The other monomer units include $CH_2$=CHRf (wherein Rf represents a $C_1$-$C_{10}$ fluoroalkyl group) units, alkyl vinyl ether units (e.g., a cyclohexyl vinyl ether unit, ethyl vinyl ether unit, butyl vinyl ether unit, and methyl vinyl ether unit), alkenyl vinyl ether units (e.g., a polyoxyethylene allyl ether unit and ethyl allyl ether unit), organosilicon compound units having a reactive $\alpha,\beta$-unsaturated group (e.g., a vinyltrimethoxysilane unit, vinyltriethoxysilane unit, and a vinyltris(methoxyethoxy)silane unit), acrylic ester units (e.g., a methyl acrylate unit and ethyl acrylate unit), methacrylic ester units (e.g., a methyl methacrylate unit and ethyl methacrylate unit), vinyl ester units (e.g., a vinyl acetate unit, vinyl benzoate unit, and a VeoVA (vinyl ester produced by Shell plc) unit), and the like.

The percentage of the other monomer units may be, for example, 0 mol% or more and 20 mol% or less, or 0 mol% or more and 10 mol% or less, based on the total monomer units.

The fluoropolymer preferably has a glass transition temperature (Tg) of 110°C or higher, more preferably 110°C or higher and 300°C or lower, even more preferably 120°C or higher and 300°C or lower, and particularly preferably 125°C or higher and 200°C or lower. A glass transition temperature within these ranges is advantageous in terms of bending durability of the fluoropolymer layer in, for example, a laminate comprising a flexible substrate.

The fluoropolymer has a mass average molecular weight of, for example, 10,000 or more and 1,000,000 or less, preferably 30,000 or more and 500,000 or less, and more preferably 50,000 or more and 300,000 or less. A molecular weight within these ranges is advantageous in terms of durability.

The fluoropolymer layer has a high indentation hardness by comprising the fluoropolymer. The fluoropolymer layer has an indentation hardness of, for example, 250 $N/mm^2$ or more and 1000 $N/mm^2$ or less, preferably 300 $N/mm^2$ or more and 800 $N/mm^2$ or less, and more preferably 350 $N/mm^2$ or more and 600 $N/mm^2$ or less.

Since the fluoropolymer has high permeability, the fluoropolymer layer can be used as an optical material. The fluoropolymer layer can have a total light transmittance of, for example, 90% or more and 99% or less, preferably 92% or more and 99% or less, and more preferably 94% or more and 99% or less.

Since the fluoropolymer also has high ultraviolet transmittance, the fluoropolymer layer can also be used as an optical material for ultraviolet light. The transmittance of the fluoropolymer layer at 193 nm or more and 410 nm or less can be, for example, 60% or more, and preferably 70% or more.

The fluoropolymer layer can have an indentation elastic modulus of, for example, 2.5 GPa or more and 10 GPa or less, preferably 2.5 GPa or more and 8 GPa or less, and more preferably 2.5 GPa or more and 6 GPa or less.

The fluoropolymer layer can have a relative permittivity at 6 GHz of, for example, 1.5 or more and 2.5 or less, preferably 1.7 or more and 2.3 or less, and more preferably 1.8 or more and 2.2 or less.

The fluoropolymer layer can have a relative permittivity at 10 GHz of, for example, 1.5 or more and 2.5 or less, preferably 1.7 or more and 2.3 or less, and more preferably 1.8 or more and 2.2 or less.

The fluoropolymer layer can have a relative permittivity at 20 GHz of, for example, 1.5 or more and 2.5 or less, preferably 1.7 or more and 2.3 or less, and more preferably 1.8 or more and 2.2 or less.

The fluoropolymer layer can have a relative permittivity at 28 GHz of, for example, 1.5 or more and 2.5 or less, preferably 1.7 or more and 2.3 or less, and more preferably 1.8 or more and 2.2 or less.

At least one of the relative permittivity at 6 GHz, the relative permittivity at 10 GHz, the relative permittivity at 20 GHz, and the relative permittivity at 28 GHz of the fluoropolymer layer can be, for example, 1.5 or more and 2.5 or less, preferably 1.7 or more and 2.3 or less, and more preferably 1.8 or more and 2.2 or less.

The relative permittivity at 6 GHz, the relative permittivity at 10 GHz, the relative permittivity at 20 GHz, and the relative permittivity at 28 GHz of the fluoropolymer layer can all be, for example, 1.5 or more and 2.5 or less, preferably 1.7 or more and 2.3 or less, and more preferably 1.8 or more and 2.2 or less.

The fluoropolymer layer can have a dielectric dissipation factor at 6 GHz of, for example, 0.00005 or more and 0.0002 or less, and preferably 0.00007 or more and 0.0002 or less.

The fluoropolymer layer can have a dielectric dissipation factor at 10 GHz of, for example, 0.0002 or less, preferably 0.00005 or more and 0.0002 or less, and more preferably 0.00007 or more and 0.0002 or less.

The fluoropolymer layer can have a dielectric dissipation factor at 20 GHz of, for example, 0.0002 or less,

preferably 0.00005 or more and 0.0002 or less, and more preferably 0.00007 or more and 0.0002 or less.

The fluoropolymer layer can have a dielectric dissipation factor at 28 GHz of, for example, 0.0002 or less, preferably 0.00005 or more and 0.0002 or less, and more preferably 0.00007 or more and 0.0002 or less.

At least one of the dielectric dissipation factor at 6 GHz, the dielectric dissipation factor at 10 GHz, the dielectric dissipation factor at 20 GHz, and the dielectric dissipation factor at 28 GHz of the fluoropolymer layer can be, for example, 0.0002 or less, preferably 0.00005 or more and 0.0002 or less, and more preferably 0.00007 or more and 0.0002 or less.

The dielectric dissipation factor at 6 GHz, the dielectric dissipation factor at 10 GHz, the dielectric dissipation factor at 20 GHz, and the dielectric dissipation factor at 28 GHz of the fluoropolymer layer can all be, for example, 0.0002 or less, preferably 0.00005 or more and 0.0002 or less, and more preferably 0.00007 or more and 0.0002 or less.

A fluoropolymer can be produced, for example, by polymerizing one or more monomers corresponding to one or more monomer units constituting the fluoropolymer by an appropriate polymerization method. For example, a fluoropolymer can be produced by polymerizing one or more monomers corresponding to unit (1).

A fluoropolymer can also be produced by polymerizing one or more monomers corresponding to unit (1), optionally with at least one monomer selected from the group consisting of fluoroolefins and other monomers.

A person skilled in the art would be able to understand monomers corresponding to the monomer units constituting a fluoropolymer. For example, a monomer corresponding to unit (1) is a compound represented by formula (M1):

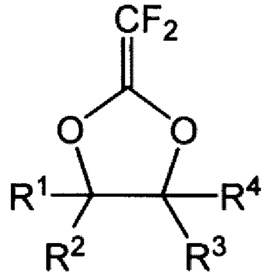

(M1)

wherein $R^1$ to $R^4$ are as defined above (this compound may be referred to as "monomer (M1)" in the present specification).

For example, a monomer corresponding to unit (1-1) is a compound represented by formula (M1-1):

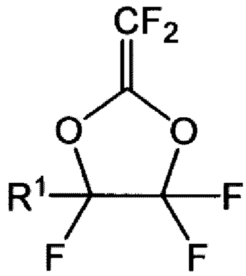

(M1-1)

wherein $R^1$ is a fluorine atom, a fluoroalkyl group, or a fluoroalkoxy group (this compound may be referred to as "monomer (M1-1)" in the present specification).

For example, the monomer corresponding to unit (1-11) is a compound represented by formula (M1-11):

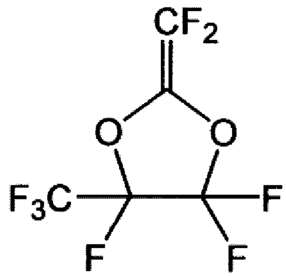

(M1-11)

(this compound may be referred to as "monomer (M1-11)" in the present specification).

The fluoroolefins for use may be monomers corresponding to the fluoroolefin units mentioned above. For example, the monomers corresponding to the tetrafluoroethylene unit, hexafluoropropylene unit, and vinylidene fluoride unit are tetrafluoroethylene ($CF_2=CF_2$), hexafluoropropylene ($CF_3CF=CF_2$), and vinylidene fluoride ($CH_2=CF_2$), respec-

tively. Thus, the details regarding fluoroolefins would be able to be understood by a person skilled in the art from the description of the corresponding fluoroolefin units.

For example, the fluoroolefin may be at least one member selected from the group consisting of fluorine-containing perhaloolefins, vinylidene fluoride, trifluoroethylene, pentafluoropropylene, and 1,1,1,2-tetrafluoro-2-propylene. Preferably, the fluoroolefin may be at least one member selected from the group consisting of chlorotrifluoroethylene, tetrafluoroethylene, hexafluoropropylene, perfluoro(methyl vinyl ether), and perfluoro(propyl vinyl ether).

The fluorine-containing perhaloolefin may be at least one member selected from the group consisting of chlorotrifluoroethylene, tetrafluoroethylene, hexafluoropropylene, perfluoro(methyl vinyl ether), perfluoro(ethyl vinyl ether), perfluoro(propyl vinyl ether), perfluoro(butyl vinyl ether), and perfluoro(2,2-dimethyl-1,3-dioxol).

The other monomers for use may be monomers corresponding to the other monomer units mentioned above. Thus, the details regarding the other monomers would be able to be understood by a person skilled in the art from the description of the corresponding other monomer units.

The polymerization method includes, for example, a method of using appropriate amounts of monomers corresponding to the monomer units that constitute the fluoropolymer, with the monomers being optionally dissolved or dispersed in a solvent (e.g., an aprotic solvent) and a polymerization initiator being optionally added, and performing polymerization (e.g., radical polymerization, bulk polymerization, solution polymerization, suspension polymerization, dispersion polymerization, or emulsion polymerization).

The polymerization method is preferably solution polymerization because solution polymerization can produce a high-concentration solution of the fluoropolymer and thereby achieve a high manufacturing yield, and is advantageous for the formation of a thick film and purification. Therefore, the fluoropolymer is preferably produced by solution polymerization. The fluoropolymer is more preferably produced by solution polymerization in which one or more monomers are polymerized in the presence of an aprotic solvent.

The solvent for use in solution polymerization of the fluoropolymer is preferably an aprotic solvent. The amount of aprotic solvent for use in the production of the fluoropolymer is, for example, 80 mass% or less, less than 80 mass%, 75 mass% or less, 70 mass% or less, 35 mass% or more and 95 mass% or less, 35 mass% or more and 90 mass% or less, 35 mass% or more and 80 mass% or less, 35 mass% or more and 70 mass% or less, 35 mass% or more and less than 70 mass%, or 60 mass% or more and 80 mass% or less, based on the sum of the mass of the monomers and the mass of the solvent. The amount can be preferably 35 mass% or more and less than 80 mass%, more preferably 40 mass% or more and 75 mass% or less, and particularly preferably 50 mass% or more and 70 mass% or less.

The aprotic solvent for use in the polymerization of fluoropolymers can be, for example, at least one member selected from the group consisting of perfluoroaromatic compounds, perfluorotrialkylamines, perfluoroalkanes, hydrofluorocarbons, perfluorocyclic ethers, hydrofluoroethers, and olefin compounds containing at least one chlorine atom.

The perfluoroaromatic compound is, for example, a perfluoroaromatic compound optionally having one or more perfluoroalkyl groups. The aromatic ring of the perfluoroaromatic compound can be at least one ring selected from the group consisting of a benzene ring, a naphthalene ring, and an anthracene ring. The perfluoroaromatic compound can have one or more (e.g., one, two, or three) aromatic rings.

The perfluoroalkyl group as a substituent is, for example, linear or branched, $C_1$-$C_6$, $C_1$-$C_5$, or $C_1$-$C_4$ perfluoroalkyl, and preferably linear or branched $C_1$-$C_3$ perfluoroalkyl.

The number of substituents is, for example, one to four, preferably one to three, and more preferably one or two. When a plurality of substituents are present, the substituents may be the same or different.

Examples of perfluoroaromatic compounds include perfluorobenzene, perfluorotoluene, perfluoroxylene, and perfluoronaphthalene.

Preferred examples of perfluoroaromatic compounds include perfluorobenzene and perfluorotoluene.

The perfluorotrialkylamine is, for example, an amine substituted with three linear or branched perfluoroalkyl groups. The number of carbon atoms of each perfluoroalkyl group is, for example, 1 to 10, preferably 1 to 5, and more preferably 1 to 4. The perfluoroalkyl groups can be the same or different, and are preferably the same.

Examples of perfluorotrialkylamines include perfluorotrimethylamine, perfluorotriethylamine, perfluorotripropylamine, perfluorotriisopropylamine, perfluorotributylamine, perfluorotri-sec-butylamine, perfluorotri-tert-butylamine, perfluorotripentylamine, perfluorotriisopentylamine, and perfluorotrineopentylamine.

Preferred examples of perfluorotrialkylamines include perfluorotripropylamine and perfluorotributylamine.

The perfluoroalkane is, for example, a linear, branched, or cyclic $C_3$-$C_{12}$ (preferably $C_3$-$C_{10}$, more preferably $C_3$-$C_6$) perfluoroalkane.

Examples of perfluoroalkanes include perfluoropentane, perfluoro-2-methylpentane, perfluorohexane, perfluoro-2-methylhexane, perfluoroheptane, perfluorooctane, perfluorononane, perfluorodecane, perfluorocyclohexane, perfluoro(methylcyclohexane), perfluoro(dimethylcyclohexane) (e.g., perfluoro(1,3-dimethylcyclohexane)), and perfluorodecalin.

Preferred examples of perfluoroalkanes include perfluoropentane, perfluorohexane, perfluoroheptane, and perfluorooctane.

The hydrofluorocarbon is, for example, a $C_3$-$C_8$ hydrofluorocarbon. Examples of hydrofluorocarbons include $CF_3CH_2CF_2H$, $CF_3CH_2CF_2CH_3$, $CF_3CHFCHFC_2F_5$, 1,1,2,2,3,3,4-heptafluorocyclopentane, $CF_3CF_2CF_2CF_2CH_2CH_3$, $CF_3CF_2CF_2CF_2CF_2CHF_2$, and $CF_3CF_2CF_2CF_2CF_2CF_2CH_2CH_3$.

Preferred examples of hydrofluorocarbons include $CF_3CH_2CF_2H$ and $CF_3CH_2CF_2CH_3$.

The perfluorocyclic ether is, for example, a perfluorocyclic ether optionally having one or more perfluoroalkyl groups. The ring of the perfluorocyclic ether may be a 3- to 6-membered ring. The ring of the perfluorocyclic ether may have one or more oxygen atoms as a ring-constituting atom. The ring preferably has one or two oxygen atoms, and more preferably one oxygen atom.

The perfluoroalkyl group as a substituent is, for example, linear or branched $C_1$-$C_6$, $C_1$-$C_5$, or $C_1$-$C_4$ perfluoroalkyl. The perfluoroalkyl group is preferably linear or branched $C_1$-$C_3$ perfluoroalkyl.

The number of substituents is, for example, one to four, preferably one to three, and more preferably one or two. When a plurality of substituents are present, they may be the same or different.

Examples of perfluorocyclic ethers include perfluorotetrahydrofuran, perfluoro-5-methyltetrahydrofuran, perfluoro-5-ethyltetrahydrofuran, perfluoro-5-propyltetrahydrofuran, perfluoro-5-butyltetrahydrofuran, and perfluorotetrahydropyran.

Preferred examples of perfluorocyclic ethers include perfluoro-5-ethyltetrahydrofuran and perfluoro-5-butyltetrahydrofuran.

The hydrofluoroether is, for example, a fluorine-containing ether.

The hydrofluoroether preferably has a global warming potential (GWP) of 400 or less, and more preferably 300 or less.

Examples of hydrofluoroethers include $CF_3CF_2CF_2CF_2OCH_3$, $CF_3CF_2CF(CF_3)OCH_3$, $CF_3CF(CF_3)CF_2OCH_3$, $CF_3CF_2CF_2CF_2OC_2H_5$, $CF_3CH_2OCF_2CHF_2$, $C_2F_5CF(OCH_3)C_3F_7$, $(CF_3)_2CHOCH_3$, $(CF_3)_2CFOCH_3$, $CHF_2CF_2OCH_2CF_3$, $CHF_2CF_2CH_2OCF_2CHF_2$, $CF_3CHFCF_2OCH_3$, $CF_3CHFCF_2OCF_3$, trifluoromethyl 1,2,2,2-tetrafluoroethyl ether (HFE-227me), difluoromethyl 1,1,2,2,2-pentafluoroethyl ether (HFE-227mc), trifluoromethyl 1,1,2,2-tetrafluoroethyl ether (HFE-227pc), difluoromethyl 2,2,2-trifluoroethyl ether (HFE-245mf), 2,2-difluoroethyltrifluoromethyl ether (HFE-245pf), 1,1,2,3,3,3-hexafluoropropylmethyl ether ($CF_3CHFCF_2OCH_3$), 1,1,2,2-tetrafluoroethyl 2,2,2-trifluoroethyl ether ($CHF_2CF_2OCH_2CF_3$), and 1,1,1,3,3,3-hexafluoro-2-methoxypropane ($(CF_3)_2CHOCH_3$).

Preferred examples of hydrofluoroethers include $CF_3CF_2CF_2CF_2OCH_3$, $CF_3CF_2CF_2CF_2OC_2H_5$, $CF_3CH_2OCF_2CHF_2$, and $C_2F_5CF(OCH_3)C_3F_7$.

The hydrofluoroether is preferably a compound represented by the following formula (B1):

$$R^{21}\text{-O-}R^{22} \qquad (B1),$$

wherein $R^{21}$ is linear or branched perfluorobutyl and $R^{22}$ is methyl or ethyl.

The olefin compound containing at least one chlorine atom is a $C_2$-$C_4$ (preferably $C_2$-$C_3$) olefin compound containing at least one chlorine atom in its structure. The olefin compound containing at least one chlorine atom is a compound in which at least one of the hydrogen atoms bonded to the carbon atoms in a $C_2$-$C_4$ hydrocarbon having one or two (preferably one) carbon-carbon double bonds (C=C) is replaced with chlorine. A compound in which at least one of the hydrogen atoms bonded to two carbon atoms constituting the carbon-carbon double bond in a $C_2$-$C_4$ hydrocarbon is replaced with chlorine is preferred.

The number of chlorine atoms is one to the maximum substitutable number. The number of chlorine atoms may be, for example, one, two, three, four, or five.

The olefin compound containing at least one chlorine atom may contain at least one (e.g., one, two, three, four, or five) fluorine atom.

Examples of olefin compounds containing at least one chlorine atom include $CH_2$=CHCl, CHCl=CHCl, $CCl_2$=CHCl, $CCl_2$=$CCl_2$, $CF_3CH$=CHCl, $CHF_2CF$=CHCl, $CFH_2CF$=CHCl, $CF_3CCl$=CFCl, $CF_2HCl$=CFCl, and $CFH_2Cl$=CFCl.

Preferred examples of olefin compounds containing at least one chlorine atom include CHCl=CHCl, $CHF_2CF$=CHCl, $CF_3CH$=CHCl, and $CF_3CCl$=CFCl.

As the aprotic solvent, a hydrofluoroether is preferable because it has less environmental impact during use and polymers can be dissolved at high concentrations in it.

Preferred examples of polymerization initiators used in production of the fluoropolymer include di-n-propyl peroxydicarbonate, diisopropyl peroxydicarbonate, diisobutyryl peroxide, di(ω-hydro-dodecafluoroheptanoyl)peroxide, di(ω-hydro-hexadecafluorononanoyl)peroxide, ω-hydro-dodecafluoroheptanoyl-ω-hydro-hexadecafluorononanoyl-peroxide, benzoyl peroxide, tert-butyl peroxypivalate, tert-hexyl peroxypivalate, ammonium persulfate, sodium persulfate, and potassium persulfate.

Particularly preferred examples of polymerization initiators include di-n-propyl peroxydicarbonate, diisopropyl peroxydicarbonate, diisobutyryl peroxide, di(ω-hydro-dodecafluoroheptanoyl)peroxide, benzoyl peroxide, tert-butyl peroxypivalate, tert-hexyl peroxypivalate, and ammonium persulfate.

The amount of the polymerization initiator for use in the polymerization reaction can be, for example, 0.0001 g or more and 0.05 g or less, preferably 0.0001 g or more and 0.01 g or less, and more preferably 0.0005 g or more and 0.008 g or less, per gram of all of the monomers subjected to the reaction.

The temperature of the polymerization reaction can be, for example, -10°C or higher and 160°C or lower, preferably 0°C or higher and 160°C or lower, and more preferably 0°C or higher and 100°C or lower.

The reaction time for the polymerization reaction is preferably 0.5 hours or more and 72 hours or less, more preferably 1 hour or more and 48 hours or less, and even more preferably 3 hours or more and 30 hours or less.

The polymerization reaction can be performed in the presence or absence of an inert gas (e.g., nitrogen gas), and preferably in the presence of an inert gas.

The polymerization reaction can be performed under reduced pressure, atmospheric pressure, or increased pressure.

The polymerization reaction can be performed by adding one or more monomers to an aprotic solvent containing a polymerization initiator and subjecting it to polymerization conditions. The polymerization reaction can also be performed by adding a polymerization initiator to an aprotic solvent containing one or more monomers and subjecting it to polymerization conditions.

The fluoropolymer produced by the polymerization reaction may be purified, if desired, by a conventional method, such as extraction, dissolution, concentration, filtration, precipitation, reprecipitation, dehydration, adsorption, or chromatography, or a combination of these methods. Alternatively, a solution of the fluoropolymer produced by the polymerization reaction, a dilute solution thereof, or a mixture of the solution with other optional components or the like may be dried or heated (e.g., 30°C or higher and 150°C or lower) to form a film containing the fluoropolymer.

The content of the fluoropolymer in the fluoropolymer layer can be, for example, 50 mass% or more and 100 mass% or less, preferably 60 mass% or more and 100 mass% or less, more preferably 80 mass% or more and 100 mass% or less, and particularly preferably 90 mass% or more and 100 mass% or less, based on the total mass of the fluoropolymer layer.

The fluoropolymer layer may comprise other components in addition to the fluoropolymer. Such other components may be known components according to the use of the laminate, such as colorants, light-diffusing agents, fillers, plasticizers, viscosity modifiers, flexibilizers, light-resistant stabilizers, reaction inhibitors, and adhesion promoters.

The fluoropolymer layer may comprise other components in appropriate amounts as long as the effects of the present disclosure are obtained. The content of the other components can be, for example, 0 mass% or more and 50 mass% or less, preferably 0 mass% or more and 40 mass% or less, more preferably 0 mass% or more and 20 mass% or less, and particularly preferably 0 mass% or more and 10 mass% or less, based on the total mass of the fluoropolymer layer.

The thickness of the fluoropolymer layer can be appropriately selected according to the functions etc. required for the fluoropolymer layer, and can be, for example, 10 nm or more, 10 nm or more and 1000 μm or less, 30 nm or more and 500 μm or less, or 50 nm or more and 500 μm or less.
The thickness can be preferably 100 nm or more and 500 μm or less, more preferably 500 nm or more and 300 μm or less, even more preferably 800 nm or more and 200 μm or less, and particularly preferably 10 μm or more and 200 μm or less. When the average film thickness is within these ranges, it is advantageous in terms of abrasion resistance.

The fluoropolymer layer can be produced, for example, by drying or heating a liquid obtained by dissolving or dispersing the fluoropolymer in a solvent to thus remove the solvent from the liquid. Preferably, the fluoropolymer layer can be produced by removing the solvent from the coating agent of the present disclosure described below.

The laminate comprises one or more other layers in addition to the fluoropolymer layer. The one or more other layers are not limited as long as they can form a laminate with the fluoropolymer layer, and they may be appropriately selected by a person skilled in the art according to the use etc. of the laminate. Examples of the other layers include insulating layers (e.g., insulating layers for use in printed circuit boards, semiconductor package substrates, antennas, transformers, capacitors, signal wire (e.g., electric wire), high-frequency transmission lines (e.g., automotive millimeter-wave radar substrates), and substrates for high-speed communications), transparent layers (e.g., an acrylic hard coat layer (e.g., a layer obtained by polymerization of an acrylic monomer in the presence of a photoinitiator), an epoxy hard coat layer (e.g., a layer obtained by polymerization of an epoxy monomer in the presence of a photoinitiator), a polyethylene terephthalate (PET) layer, and a cellulose triacetate (TAC) layer), semiconductor substrates (e.g., an Si substrate, $SiO_2$ substrate, GaN substrate, GaAs substrate, and SiN substrate), display substrates (e.g., optical glass and optical resin), and light-emitting-element-containing substrates (e.g., ultraviolet-light-emitting-element-containing substrate, near-ultraviolet light-emitting-element-containing substrate, and blue-light-emitting-element-containing substrate). These substrates often have a multilayer structure; thus, one or more other layers may be present between these substrates and the fluoropolymer layer, or one or more other layers may be laminated on the fluoropolymer layer. The order of the layers in the laminate can be appropriately selected according to the purpose of use etc. of each layer.

When the laminate is for use in optical applications, display protection applications, or other applications in which light transmittance is required, the total light transmittance of the other layers (e.g., a display substrate) is preferably

90% or more.

The fluoropolymer layer is also useful as a water-repellent layer, oil-repellent layer, low-reflection layer, antifouling layer, non-adhesive layer, water-proof layer, moisture-proof layer, chemical-resistant layer, etching protection layer, low-refractive-index layer, gas barrier layer, patterned layer, etc.

The fluoropolymer layer may be used as, for example, an antifouling, antireflection layer for solar cell cover glass, a moisture-proof, antireflection layer for deliquescent crystalline glass or phosphate glass, a surface-protection, antifouling layer for phase-shift masks or photomasks, a liquid-repellent layer of photoresist for immersion lithography, a mold release layer of contact lithography masks, a mold release layer of a nanoimprint mold, a passivation film layer of semiconductor devices or integrated circuits, a liquid crystal alignment film layer of liquid crystal display devices, a lubrication layer of magnetic recording media, an electret film layer, a chemical-resistant layer for MEMS processes, antifouling layer for medical devices, a chemical-resistant layer of a device that uses microfluidics technology, an antifouling layer, a bio-resistant layer or a liquid-repellent layer, a water-repellent layer with a hydrophilic or water-repellent pattern, a patterned optical element layer, or the like.

Therefore, the laminate of the present disclosure may be obtained by replacing these functional layers in a conventional laminate in which these functional layers are laminated with the fluoropolymer layer. In this case, a person skilled in the art would be able to understand the details of the structure, materials, shape, etc. of the other layers that constitute the laminate.

For example, the laminate may be a laminate for printed circuits, a laminate for semiconductor package substrates, a capacitor laminate, an electrical wire laminate, an optical laminate, a light-emitting laminate, and the like.

The laminate for printed circuits is, for example, a laminate in which the fluoropolymer layer is formed on an insulating material layer formed from an epoxy polymer, a polyimide compound, a liquid crystal polymer, etc., and a conductive layer is formed on the fluoropolymer layer.

The laminate for semiconductor package substrates is, for example, a laminate in which the fluoropolymer layer is formed on a build-up film layer formed from an epoxy polymer or an insulating material layer formed from a BT resin etc., and a conductive layer is formed on the fluoropolymer layer.

The capacitor laminate is, for example, a laminate in which the fluoropolymer layer and a high-dielectric layer are formed between two electrically conducting layers (e.g., aluminum conducting layers).

The electrical wire laminate is, for example, a laminate in which the fluoropolymer layer is formed around copper wire, and a protective layer (e.g., polyamide, polyvinyl chloride) is formed around the fluoropolymer layer. The optical laminate is, for example, an antireflection optical laminate in which a hard coat layer of an acrylic polymer, epoxy polymer, etc. is formed on a PET or TAC layer, and the fluoropolymer layer is formed on the hard coat layer.

The light-emitting laminate is, for example, a laminate in which the fluoropolymer layer is formed on a light-emitting-element-containing substrate or a light-emitting element.

## Coating Agent

One embodiment of the present disclosure is a coating agent for forming the fluoropolymer layer of a laminate comprising a specific fluoropolymer layer (a layer containing a fluoropolymer).

The coating agent may comprise a fluoropolymer and an aprotic solvent.

The fluoropolymer in the coating agent may be the fluoropolymer described above for the laminate. Therefore, the details of the fluoropolymer for the laminate are applicable to the details of the fluoropolymer for the coating agent.

The content of the fluoropolymer in the coating agent can be, for example, 5 mass% or more and 65 mass% or less, 10 mass% or more and 65 mass% or less, 20 mass% or more and 65 mass% or less, 30 mass% or more and 65 mass% or less, more than 30 mass% and 65 mass% or less, or 20 mass% or more and 40 mass% or less, based on the total mass of the coating agent. The content is preferably more than 20 mass% and 65 mass% or less, more preferably 25 mass% or more and 60 mass% or less, and particularly preferably 30 mass% or more and 50 mass% or less.

The aprotic solvent in the coating agent may be the aprotic solvent described above for the laminate. Therefore, the details of the aprotic solvent for the laminate are applicable to the details of the aprotic solvent for the coating agent.

The content of the aprotic solvent in the coating agent can be, for example, 35 mass% or more and 95 mass% or less, 35 mass% or more and 90 mass% or less, 35 mass% or more and 80 mass% or less, 35 mass% or more and 70 mass% or less, 35 mass% or more and less than 70 mass%, or 60 mass% or more and 80 mass% or less, based on the total mass of the coating agent. The content is preferably 35 mass% or more and less than 80 mass%, more preferably 40 mass% or more and 75 mass% or less, and particularly preferably 50 mass% or more and 70 mass% or less.

The coating agent may comprise a polymerization initiator. The polymerization initiator for the coating agent may be the polymerization initiator described above for the laminate. Therefore, the details of the polymerization initiator for the laminate are applicable to the details of the polymerization initiator for the coating agent.

The content of the polymerization initiator in the coating agent is, for example, 0.00001 mass% or more and 10 mass% or less, preferably 0.00005 mass% or more and 10 mass% or less, and more preferably 0.0001 mass% or

more and 10 mass% or less, based on the total mass of the coating agent.

The coating agent may comprise the fluoropolymer and an aprotic solvent, and optionally a polymerization initiator and optionally other components, in appropriate amounts. Examples of other components can include colorants, light-diffusing agents, various fillers, plasticizers, viscosity modifiers, flexibilizers, light-resistant stabilizers, reaction inhibitors, and adhesion promoters. The content of the other components can be, for example, 0.01 mass% or more and 50 mass% or less, preferably 0.01 mass% or more and 30 mass% or less, more preferably 0.01 mass% or more and 20 mass% or less, based on the total mass of the coating agent.

The coating agent can be produced by mixing the fluoropolymer and an aprotic solvent, optionally with a polymerization initiator and optionally with other components.

The coating agent can be produced by mixing a polymerization reaction mixture obtained by the solution polymerization of fluoropolymer described above (this reaction mixture contains at least a fluoropolymer and an aprotic solvent) optionally with an aprotic solvent and/or other components.

When solution polymerization is performed, the fluoropolymer concentration or the amount of fluoropolymer dissolved in the polymerization reaction mixture can be increased, and the step of isolating the fluoropolymer from the polymerization reaction mixture can be omitted. For this reason, the coating agent preferably contains a polymerization reaction mixture obtained by solution polymerization.

In the coating agent, the content of the polymerization reaction mixture of solution polymerization can be appropriately selected according to the concentration of the fluoropolymer in the polymerization reaction mixture and the functions, thickness, etc. of the fluoropolymer layer to be produced. The content of the polymerization reaction mixture of solution polymerization in the coating agent can be, for example, 5 mass% or more and 100 mass% or less, preferably 20 mass% or more and 100 mass% or less, and more preferably 30 mass% or more and 100 mass% or less, based on the total mass of the coating agent.

The coating agent comprising an aprotic solvent in which the fluoropolymer is dissolved or dispersed can form a fluoropolymer layer, for example, by applying the agent to a portion in which the formation of fluoropolymer layer is required by an appropriate method (e.g., spray coating, dip coating, bar coating, gravure coating, roll coating, ink jet, spin coating), and then removing the solvent by drying, heating, etc. After application of the coating agent, heating is preferably performed. The drying or heating temperature is, for example, 30°C or higher and 150°C or lower, and preferably 30°C or higher and 80°C or lower.

For example, a fluoropolymer layer can be formed by applying the coating agent of the present disclosure, followed by drying in a dryer at 80°C. Alternatively, after a fluoropolymer film is formed by applying the coating agent of the present disclosure, one or more other layers can be formed on this film.

Although embodiments are described above, it can be understood that various modifications in form and details may be made without departing from the spirit and scope of the claims.

## Examples

An embodiment of the present disclosure is described in more detail below with Examples; however, the present disclosure is not limited to these.

The symbols and abbreviations in the Examples are used with the following meanings.

Initiator solution (1): a methanol solution containing 50 mass% di-n-propyl peroxydicarbonate (10-hour half-life temperature: 40°C)
Fluoropolymer (1-11): a polymer composed of unit (1-11)
Mw: mass average molecular weight

### GPC Analysis Method (Measurement of Mass Average Molecular Weight of Fluoropolymer)

#### Sample Preparation Method

A polymer was dissolved in perfluorobenzene to prepare a 2 mass% polymer solution, and the polymer solution was passed through a membrane filter (0.22 μm) to obtain a sample solution.

#### Measurement Method

Standard sample for measurement of molecular weight: polymethyl methacrylate
Detection method: RI (differential refractometer)

Confirmation of Polymer Solubility

Whether the polymer was dissolved in the liquid was determined as follows.

Each of the prepared liquids was visually observed, and when no undissolved polymer was observed and the entire liquid flowed uniformly at room temperature, it was determined that the polymer was dissolved.

Average Film Thickness

The average film thickness was defined as the average value of a thickness measured 5 times with a micrometer. The average film thickness was calculated by measuring the thickness of the base material before film formation and the thickness of the base material after film formation (the sum of the film thickness and the base material thickness) 5 times each with a micrometer, and subtracting the average value of the thickness before film formation from the average value of the thickness after film formation.

Glass Transition Temperature

The temperature was increased (first run), decreased, and then increased (second run) at 10°C/minute in the temperature range of 30°C or higher and 200°C or lower using a DSC (differential scanning calorimeter; Hitachi High-Tech Science Corporation, DSC7000); the midpoint of the endothermic curve in the second run was determined to be the glass transition temperature (°C).

Relative Permittivity and Dielectric Dissipation Factor

The relative permittivity and dielectric dissipation factor at frequencies of 10, 20, 28, 60, and 80 GHz were determined by a split-cylinder resonator method. A resonator corresponding to each frequency produced by KANTO Electronic Application and Development Inc. was used as the split cylinder, and a Keysight N5290A was used as the network spectrum analyzer. For measurement at 10 GHz, a film with a thickness of 100 μm, a width of 62 mm, and a length of 75 mm was used as the sample to be measured, and for measurement at 20, 28, 60, and 80 GHz, a film with a thickness of 100 μm, a width of 34 mm, and a length of 45 mm was used as the sample to be measured. The measurement temperature was 25°C.

The relative permittivity and dielectric dissipation factor at 6 GHz were measured using a cavity resonator produced by KANTO Electronic Application and Development Inc. The sample was formed into a cylinder shape (2 mm dia. × 110 mm).

The real part of the complex relative permittivity was determined from the change in the resonance frequency indicated by the cavity resonator, and the imaginary part of the complex relative permittivity was determined from the change in the Q value. The relative permittivity and dielectric dissipation factor were then calculated according to the following formulas.

$$\varepsilon_r^* = \varepsilon_r' - j\varepsilon_r''$$

$$\varepsilon_r' = \varepsilon_r$$

$$\varepsilon_r'' = \varepsilon_r \tan\delta$$

$$\tan\delta = \frac{\varepsilon_r''}{\varepsilon_r'}$$

In the formulas, $\varepsilon_r^*$ represents a complex relative permittivity, $\varepsilon_r'$ represents a relative permittivity, $\varepsilon_r''$ represents a relative dielectric loss factor, and tan $\delta$ represents a dielectric dissipation factor.

Indentation Hardness and Indentation Elastic Modulus

The indentation hardness ($H_{IT}$; indentation hardness) of the sample was measured using an ENT-2100 ultra-fine hardness tester produced by Nanotec Corporation. The indentation elastic modulus was also measured at the same time. The test was performed by adjusting the indentation depth to be 1/10 or less of the thickness.

Measurement Method for Total Light Transmittance and Haze

The total light transmittance and haze were measured using an NDH 7000SPII haze meter (produced by Nippon Denshoku Industries Co., Ltd.) in accordance with JIS K7136 (haze value) and JIS K7361-1 (total light transmittance). A film with an average film thickness of 100 μm was used as the sample to be measured. The sample was produced by coating a glass plate with a coating agent such that the thickness after drying was 100 μm, performing drying at 80°C for 4 hours, and peeling off the resulting dried film with an average film thickness of 100 μm from the glass plate.

Transmittance at Each Wavelength

The transmittance at a specific wavelength of a sample (a film with an average film thickness of 100 μm) was measured using a Hitachi U-4100 spectrophotometer. An integrating sphere detector was used as the detector.

Preparation Example 1: Polymerization of Fluoropolymer Comprising Unit (1-11) as Main Component and Production of Polymer Solution (Polymerization Reaction Mixture)

The monomer (M1-11) (10 g), ethyl nonafluorobutyl ether (20 g) as a solvent, and the initiator solution (1) (0.041 g) were placed in a 50-mL glass container, and a polymerization reaction was then performed for 20 hours while the mixture was heated such that the internal temperature was 40°C, thereby producing a fluoropolymer (1-11) (9.0 g, Mw: 97533). The fluoropolymer in the polymerization reaction mixture was dissolved, and the concentration was 31 mass%.

The weight of the polymer in the composition was measured by distilling off the unreacted starting material, the solvent, the initiator residue, and the impurities contained in a trace amount in the monomer by vacuum drying at 120°C after the completion of the polymerization reaction.

The glass transition temperature of the vacuum-dried polymer was 129°C.

The vacuum-dried polymer was separately melt-molded into a cylinder shape (2 mm dia. × 110 mm), and the electrical properties at 6 GHz were measured. The results are shown below.

Relative permittivity (6 GHz): 1.99
Dielectric dissipation factor (6 GHz): 0.00011

Preparation Example 2: Polymerization of Fluoropolymer Comprising Unit (1-11) as Main Component and Production of Polymer Solution (Polymerization Reaction Mixture)

The monomer (M1-11) (10 g), perfluorotripropylamine (10 g) as a solvent, and the initiator solution (1) (0.052 g) were placed in a 20-mL glass container, and a polymerization reaction was then performed for 20 hours while the mixture was heated such that the internal temperature was 40°C, thereby producing a fluoropolymer (1-11) (9.5 g, Mw: 213475). The fluoropolymer in the reaction mixture was dissolved, and the concentration was 49 mass%.

The weight of the polymer in the composition was measured by distilling off the unreacted starting material, the solvent, the initiator residue, and the impurities contained in a trace amount in the monomer by vacuum drying at 120°C after the completion of the polymerization reaction.

Preparation Example 3

Ethyl nonafluorobutyl ether was further added to the polymerization reaction mixture obtained in Preparation Example 1 to obtain a solution of fluoropolymer at a concentration of 10 mass%.

Comparative Preparation Example 1: Production of Teflon (Registered Trademark) Solution

Teflon (registered trademark) AF1600 (2.0 g, Mw: 229738), which is a commercially available fluoropolymer, was added to methyl nonafluorobutyl ether (8.0 g), and the mixture was stirred at room temperature for 2 days to prepare a uniformly dissolved solution.

Teflon (registered trademark) AF1600 contains the monomer unit represented by the following formula (10) and the monomer unit represented by the following formula (20) in a ratio of 65:35 (molar ratio).

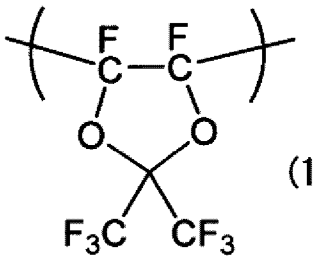
(10)
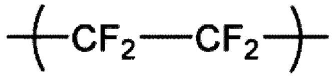
(20)

Example 1

The polymerization reaction mixture obtained in Preparation Example 1 was directly used as a coating agent, and a laminate was produced as follows.
A silicon wafer was spin-coated with the coating agent at a spin speed of 500 rpm for 2 seconds with a spin coater, and further spin-coated at 1000 rpm for 25 seconds. Next, heating was performed at 80°C for 2 hours, thereby obtaining a laminate 1 in which a uniform, transparent fluoropolymer (1-11) film (a fluoropolymer layer, average film thickness: 0.85 μm) was formed on the silicon wafer surface.

Example 2

The polymerization reaction mixture obtained in Preparation Example 1 was directly used as a coating agent, and a laminate was produced as follows.
An aluminum plate whose surface had been treated with 3-aminopropyltrimethoxysilane was coated with the coating agent such that the thickness after drying was 100 μm, and heating was performed at 80°C for 2 hours, thereby obtaining a laminate 2 in which a uniform, transparent fluoropolymer (1-11) film (a fluoropolymer layer, average film thickness: 100 μm) was formed on the aluminum plate surface.
The indentation hardness and indentation elastic modulus of the surface of the laminate 2 on the fluoropolymer layer side were 420 $N/mm^2$ and 3.3 GPa, respectively.

Comparative Example 1

A laminate 3 in which a uniform, transparent fluoropolymer layer (average film thickness: 50 μm) was formed on an aluminum plate was obtained in the same manner as in Example 2, except that the fluoropolymer solution obtained in Comparative Preparation Example 1 was used as the coating agent.
The indentation hardness and indentation elastic modulus of the surface of the laminate 3 on the fluoropolymer layer side were 145 $N/mm^2$ and 2 GPa, respectively.

Comparative Example 2

Attempts were made to thermally bond a NEOFLON FEP NF-0100 film (a fluoropolymer film, produced by Daikin Industries, Ltd.) at 350°C to an aluminum plate whose surface had been treated with 3-aminopropyltrimethoxysilane; however, the film could not adhere to the aluminum plate, and a laminate was not obtained.

Example 3

The polymerization reaction mixture obtained in Preparation Example 2 was directly used as a coating agent, and a laminate was produced as follows.
A quartz glass plate whose surface had been treated with 3-aminopropyltrimethoxysilane was coated with the coating agent such that the thickness after drying was 100 μm, and heating was performed at 80°C for 2 hours, thereby obtaining a laminate 4 in which a uniform, transparent fluoropolymer (1-11) film (a fluoropolymer layer, average film thickness: 100 μm) was formed on the quartz glass plate surface.
The transparency of the laminate 4 was measured. The results are shown below.

Total light transmittance: 95%
Haze: 0.48%
Transmittance (193 nm): 70%
Transmittance (550 nm): 95%

Example 4

The polymerization reaction mixture obtained in Preparation Example 2 was directly used as a coating agent, and a film was produced as follows.

A glass substrate was coated with the coating agent such that the thickness after drying was 50 μm, and drying was performed at 80°C for 4 hours to form a transparent film. The film was then peeled off from the glass plate, thereby obtaining a fluoropolymer (1-11) film having an average film thickness of 50 μm. The electrical properties, indentation hardness, and indentation elastic modulus of the obtained film were measured. The results are shown below.

Relative permittivity (10 GHz): 2.02
Dielectric dissipation factor (10 GHz): 0.00015
Relative permittivity (20 GHz): 2.11
Dielectric dissipation factor (20 GHz): 0.00016
Relative permittivity (28 GHz): 2.09
Dielectric dissipation factor (28 GHz): 0.00019
Relative permittivity (60 GHz): 2.12
Dielectric dissipation factor (60 GHz): 0.00036
Relative permittivity (80 GHz): 2.10
Dielectric dissipation factor (80 GHz): 0.00031
Indentation hardness: 415 $N/mm^2$
Indentation elastic modulus: 3.5 GPa

Example 5

An FR4 (Flame Retardant Type 4) plate, which is a material of a printed circuit board, was coated with the solution obtained in Preparation Example 3 such that the thickness after drying was 20 μm, and heating was performed at 80°C for 2 hours, thereby obtaining a laminate 6 in which a uniform, transparent fluoropolymer (1-11) film (a fluoropolymer layer, average film thickness: 20 μm) was formed on the printed circuit board surface.

Example 6

A substrate on which a commercially available UV-LED chip was mounted was surface-treated with 3-aminopropyltrimethoxysilane and then coated with the polymerization reaction mixture obtained in Preparation Example 1 such that the thickness after drying was about 100 μm. Heating was then performed at 80°C for 2 hours, thereby obtaining a laminate 7 in which a uniform, transparent fluoropolymer (1-11) film (a fluoropolymer layer, average film thickness: 100 μm) was formed on the UV-LED chip-mounted substrate surface.

**Claims**

**1.** A laminate comprising a fluoropolymer layer,

wherein
the fluoropolymer comprises, as a main component, a monomer unit represented by formula (1):

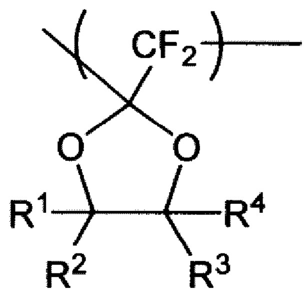

(1)

wherein $R^1$ to $R^4$ are each independently a fluorine atom, a fluoroalkyl group, or a fluoroalkoxy group.

2. The laminate according to claim 1, wherein the fluoropolymer further comprises a fluoroolefin unit.

3. The laminate according to claim 2, wherein the fluoroolefin unit is at least one member selected from the group consisting of a fluorine-containing perhaloolefin unit, a vinylidene fluoride unit, a trifluoroethylene unit, a pentafluoropropylene unit, and a 1,1,1,2-tetrafluoro-2-propylene unit.

4. The laminate according to claim 3, wherein the fluorine-containing perhaloolefin unit is at least one member selected from the group consisting of a chlorotrifluoroethylene unit, a tetrafluoroethylene unit, a hexafluoropropylene unit, a perfluoro(methyl vinyl ether) unit, a perfluoro(ethyl vinyl ether) unit, a perfluoro(propyl vinyl ether) unit, a perfluoro(butyl vinyl ether) unit, and a perfluoro(2,2-dimethyl-1,3-dioxol) unit.

5. The laminate according to claim 2, wherein the fluoroolefin unit is at least one member selected from the group consisting of a chlorotrifluoroethylene unit, a tetrafluoroethylene unit, a hexafluoropropylene unit, a perfluoro(methyl vinyl ether) unit, and a perfluoro(propyl vinyl ether) unit.

6. The laminate according to any one of claims 1 to 5,
wherein the fluoropolymer layer has an average thickness of 10 nm or more.

7. The laminate according to any one of claims 1 to 6, further comprising an insulating layer as one or more other layers constituting the laminate.

8. The laminate according to claim 7, wherein the insulating layer is a printed circuit board.

9. The laminate according to claim 7 or 8, wherein the fluoropolymer layer is an insulating film for printed circuit boards.

10. The laminate according to any one of claims 1 to 6, further comprising a semiconductor substrate as one or more other layers constituting the laminate.

11. The laminate according to claim 10, wherein the semiconductor substrate is a GaN or GaAs substrate.

12. The laminate according to claim 10 or 11, wherein the fluoropolymer layer is an insulating film for semiconductors.

13. The laminate according to any one of claims 1 to 6, further comprising an acrylic hard coat layer, an epoxy hard coat layer, a polyethylene terephthalate layer, or a cellulose triacetate layer as one or more other layers constituting the laminate.

14. The laminate according to claim 13, wherein the fluoropolymer layer is a protective film for displays.

15. The laminate according to any one of claims 1 to 6, 13, and 14, wherein the one or more other layers constituting the laminate have a total light transmittance of 90% or more.

16. The laminate according to claim 15, wherein the one or more other layers comprise optical glass or optical resin.

17. The laminate according to any one of claims 1 to 6, further comprising a light-emitting-element-containing substrate as one or more other layers constituting the laminate.

18. The laminate according to claim 17, wherein the fluoropolymer layer is a light-emitting-element-encapsulating layer.

19. The laminate according to any one of claims 1 to 18, wherein the number of layers constituting the laminate is 2, 3, or 4.

20. The laminate according to any one of claims 1 to 19, wherein the fluoropolymer layer has an indentation hardness of 250 $N/mm^2$ or more and 1000 $N/mm^2$ or less.

21. The laminate according to any one of claims 1 to 20, wherein the fluoropolymer layer has an indentation elastic modulus of 2.5 GPa or more and 10 GPa or less.

22. The laminate according to any one of claims 1 to 21, wherein the fluoropolymer has a glass transition temperature of 110°C or higher.

**23.** The laminate according to any one of claims 1 to 22, wherein the fluoropolymer layer has a relative permittivity at 6 GHz of 1.5 or more and 2.5 or less.

**24.** The laminate according to any one of claims 1 to 23, wherein the fluoropolymer layer has a dielectric dissipation factor at 6 GHz of 0.00005 or more and 0.0002 or less.

**25.** A coating agent for forming a fluoropolymer layer of a laminate comprising the fluoropolymer layer, the coating agent comprising a fluoropolymer and an aprotic solvent,

wherein
the fluoropolymer comprises, as a main component, a monomer unit represented by formula (1):

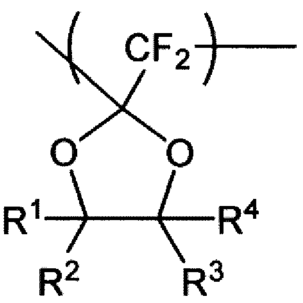

(1)

wherein $R^1$ to $R^4$ are each independently a fluorine atom, a fluoroalkyl group, or a fluoroalkoxy group.

**26.** The coating agent according to claim 25, wherein the content of the fluoropolymer is 20 mass% or more and 65 mass% or less based on the total mass of the coating agent.

**27.** The coating agent according to claim 25 or 26, wherein the aprotic solvent is at least one solvent selected from the group consisting of perfluoroaromatic compounds, perfluorotrialkylamines, perfluoroalkanes, hydrofluorocarbons, perfluorocyclic ethers, hydrofluoroethers, and olefin compounds containing at least one chlorine atom.

**28.** The coating agent according to any one of claims 25 to 27, wherein the aprotic solvent is at least one hydrofluoroether.

| INTERNATIONAL SEARCH REPORT | International application No. PCT/JP2021/000252 |
|---|---|

A. CLASSIFICATION OF SUBJECT MATTER

B05D 7/24(2006.01)i; B32B 27/30(2006.01)i; C08F 16/24(2006.01)i; C09D 123/28(2006.01)i

FI: B32B27/30 D; C09D123/28; C08F16/24; B05D7/24 302L

According to International Patent Classification (IPC) or to both national classification and IPC

B. FIELDS SEARCHED

Minimum documentation searched (classification system followed by classification symbols)

B32B1/00-43/00; B05D7/24; C08F16/24; C09D123/28

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2008-40262 A (DAIKIN INDUSTRIES, LTD.) 21 February 2008 (2008-02-21) claims, paragraphs [0021]-[0071], [0209]-[0214], [0231], [0254]-[0273] | 1-27 |
| Y | claims, paragraphs [0021]-[0071], [0209]-[0214], [0231], [0254]-[0273] | 28 |
| Y | JP 2012-46674 A (ASAHI GLASS CO., LTD.) 08 March 2012 (2012-03-08) claims | 28 |
| A | JP 43-29154 B1 (E. I. DU PONT DE NEMOURS AND COMPANY) 13 December 1968 (1968-12-13) claims, examples | 1-28 |

☐ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 10 March 2021 (10.03.2021) | 30 March 2021 (30.03.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/000252

| Patent Documents referred in the Report | Publication Date | Patent Family | Publication Date |
|---|---|---|---|
| JP 2008-40262 A | 21 Feb. 2008 | (Family: none) | |
| JP 2012-46674 A | 08 Mar. 2012 | (Family: none) | |
| JP 43-29154 B1 | 13 Dec. 1968 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015133505 A